# EUROPEAN PATENT APPLICATION

(11) **EP 1 127 965 A1**
(43) Date of publication of application: **29.08.2001**
(21) Application number: 00927781.5
(22) Date of filing: 17.05.2000
(51) Int. Cl.: C30B 33/08, C30B 29/18, H01L 21/306, H03H 3/02

(54) **ETCHING METHOD AND ARTICLE PROCESSED BY THE METHOD**

(30) Priority: 18.05.1999 JP 17309899
(71) Applicant: Watanabe, Takaya, Yokohama-shi, Kanagawa 227-0033 (JP)
(72) Inventor: Watanabe, Takaya, Yokohama-shi, Kanagawa 227-0033 (JP)
(74) Representative: Brunner, Michael John
(86) International application number: JP0003146
(87) International publication number: WO0070130

(57) **Abstract**

A working method is provided wherein, when etching is performed for an object having crystal such as crystal, the etching is performed so that such a defect as an etch channel or an etch pit may not appear. In an etching method wherein crystal 40 is soaked in ammonium hydrogen fluoride solution in an etching solution 10, a solution temperature controller 20 controls the temperature of the solution in the etching vessel 10 so that the etching speed is higher than the crystal growth speed of the crystal 40.

## Description

### Technical Field

This invention relates to a method for etching an object having crystal such as quartz crystal.

### Background Art

In recent years, various filters beginning with a quartz crystal oscillator or a SAW (surface acoustic wave) filter which is an electromechanical functional device which uses a piezoelectric material which is used in conformity with a flow of increase in capacity and frequency in the field of mobile communications are obliged to be ready for high frequencies. For the range 10 MHz to 100 MHz, quartz crystal oscillators and crystal filters which make use of bulk wave responses of crystal are used popularly, and for the range 100 MHz to 1 GHz, SAW filters and other SAW devices which make use of surface acoustic waves are used popularly.

Here, it is apparent that, for miniaturization and stabilization of componets of various communication equipments, a bulk wave crystal device for bulk waves which makes use of resonant frequencies of a crystal plate has fundamentally superior characteristics in terms of Q factor and the frequency stability of a device which can be implemented even when compared with a SAW device which is a surface wave device.

However, since the frequency which can be realized with bulk waves of crystal has a relationship reciprocal to the thickness of the crystal plate, in order to realize a higher frequency, the thickness of the crystal plate must be thinned. The practical production limit of the thickness of a crystal plate by double-sided polishing by mechanical working including handling of the same is 30 *µ*m, and the fundamental mode operating frequency remains 55 MHz.

Therefore, where a bulk wave crystal device of a high frequency is required, it is implemented making use of higher overtone modes such as 3rd overtone mode, 5th overtone mode, 7th overtone mode although the device characteristic which can be realized is limited by the capacitance ratio. However, it is more desirable if fundamental mode responses can be utilized. From this, engineering development of bulk wave crystal devices which are produced by working, using swept crystal free from lattice defects, the crystal chemically or physically to make part of it thin, that is, by performing mesa working for the crystal and which operate with a fundamental mode is being proceeded.

By mesa working of crystal, a desired high frequency of a bulk wave crystal device can be realized with a diaphragm structure. Ion milling is a method of physically performing mesa working of the surface structure of crystal with plasma in vacuum. It is a defect of the ion milling that the working speed for crystal is slow.

Further, a method of performing mesa working of crystal using chemical etching which attracts attention recently is investigated.

However, when mesa working of crystal is performed using the chemical etching, as reported in the 41st Annual Frequency Control Symposium, 1987, pp.183-191, an etch channel (Etch Channel: through-hole) or an etch pit (Etch Pit: roughness of the surface) caused by a dislocation of the crystal lattice occurs.

Therefore, it is a subject of the present invention to provide a working method wherein, when etching is performed for an object having crystal such as quartz crystal, the etching is performed so that such a defect as an etch channel or an etch pit may not appear.

### Disclosure of the Invention

Considering the above mentioned object, the present invention described in claim 1 is an etching method wherein a workpiece having crystal is soaked in acid solution, wherein an etching speed is higher than a crystal growth speed of the workpiece.

It has been discovered by the inventor of the present application that, as the etching speed rises, such defects as etch channels and etch pits decrease. Also it has been discovered by the inventor of the present application that, particularly where the etching speed is higher than the crystal growth speed of a workpiece, appearance of etch channels and etch pits decreases remarkably.

The present invention described in claim 2 is an etching method, comprising: a pre-etching step of soaking a workpiece having crystal in acid solution; an etching speed calculation step of calculating an etching speed in the pre-etching step; an etching time calculation step of calculating an etching time for which etching should be performed from the calculated etching speed; and a main etching step of soaking the workpiece in acid solution for the etching time; the etching speed being higher than a crystal growth speed of the workpiece.

Since the etching speed by the acid solution becomes clear, the etching time can be calculated. Consequently, the time in which etching should be performed can be determined accurately, and the etching can be performed precisely.

The present invention described in claim 3 is an etching method according to claim 2, further comprising: next to the pre-etching step, a step of soaking the workpiece in a low speed etching acid solution whose etching speed is lower than the etching speed of the acid solution.

The present invention described in claim 4 is an etching method according to any one of claims 1 to 3, wherein the acid solution has a temperature higher than 100°C.

The present invention described in claim 5 is an etching method according to any one of claims 1 to 3, wherein the acid solution is solution in which ammonium hydrogen fluoride or hydrofluoric acid is dissolved.

The present invention described in claim 6 is an etching method according to any one of claims 1 to 3, wherein the workpiece is crystal.

The present invention described in claim 7 is an etching method according to claim 6, wherein the workpiece is crystal produced by cutting from natural crystal, a raw ore of artificial crystal grown by hydrothermal synthesis or a raw ore of swept crystal.

The present invention described in claim 8 is an etching method according to any one of claims 1 to 3, wherein the workpiece is one of AlPO4, Quartz, LiTaO₃, LiNbO₃ and Li₂B₄O₇.

The present invention described in claim 9 is a workpiece worked by an etching method as set forth in any one of claims 1 to 8.

The present invention described in claim 10 is a vessel made of Teflon and having a through-hole in a side wall or a bottom thereof.

The present invention described in claim 11 is a vessel, comprising: an upper vessel made of Teflon and having a through-hole in a side wall or a bottom thereof; and a lower vessel made of Teflon and having a through-hole in a side wall or a bottom thereof; said upper vessel being placed on said lower vessel.

### Brief Description of the Drawings

FIG. 1 is a graph illustrating a relationship to an etching speed of an etch channel number /cm² and an etch pit number /cm² appearing on an etched face of a crystal plate when the crystal is etched with ammonium hydrogen fluoride solution;
FIG. 2 shows an etching apparatus for carrying out an etching method according to a first embodiment of the present invention, and wherein (a) of FIG. 2 is a general view showing an etching vessel 10 and a solution temperature control system in combination, (b) of FIG. 2 is a view showing a form wherein the etching apparatus is used with baskets 32 placed one on the other, (c) of FIG. 2 is a view showing crystal 40 before etching, and (d) of FIG. 2 is a view showing the crystal 40 after etching;
FIG. 3 is a view showing a neutralization vessel 12 and a pure water vessel 14 of the etching apparatus for carrying out the etching method according to the first embodiment of the present invention;
FIG. 4 is a flow chart illustrating operation of the first embodiment;
FIG. 5 is a cross sectional view showing a cross section of the crystal 40 etched from the two front and rear faces thereof;
FIG. 6 is a cross sectional view showing a cross section of the crystal 40 etched from the one front face thereof;
FIG. 7 is a view showing an etching apparatus for carrying out an etching method according to a second embodiment of the present invention;
FIG. 8 is a flow chart illustrating operation of the second embodiment; and
FIG. 9 is a flow chart illustrating a calculation step of an etching time in the second embodiment.

### Best Mode for Carrying out the Invention

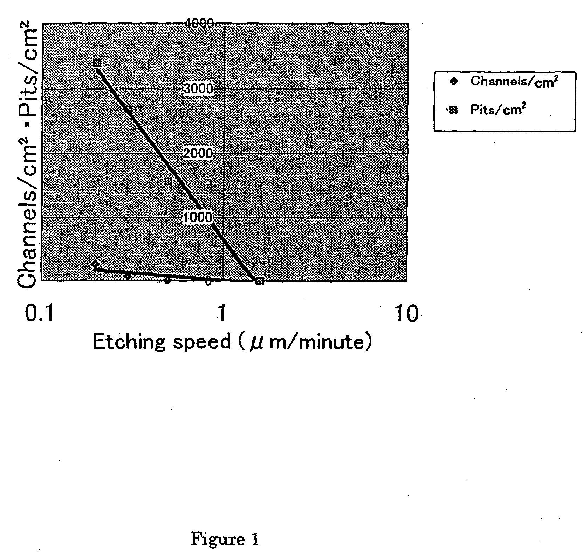

First, the principle of the present invention is described. Relationships to an etching speed of an etch channel number /cm² and an etch pit number /cm² appearing on an etched face of a swept crystal plate cut in an AT-cut and polished when the swept crystal plate is etched with ammonium hydrogen fluoride solution are illustrated in FIG. 1. It can be seen that the etch channel number is zero where the etching speed is higher than 0.6 *µ*m/minute whereas the etch pit number becomes less than approximately 700 where the etching speed exceeds 1 *µ*m/minute and no Etch Pit appears where the etching speed is higher than 1.6 *µ*m/minute.

It is to be noted that, since, with the crystal of the type mentioned, the growth speed of crystal is approximately 1.54 µm/minute at highest, where the etching speed is higher than the crystal growth speed, neither etch channel nor etch pit appears.

In other words, as the etching speed increases, such defects as etch channels and etch pits decrease. This has been discovered by the inventor of the present application. Also it has been discovered that, particularly where the etching speed is higher than the crystal growth speed of a workpiece, appearance of etch channels and etch pits decreases remarkably.

In the following, embodiments of the present invention are described with reference to the drawings.

### First Embodiment

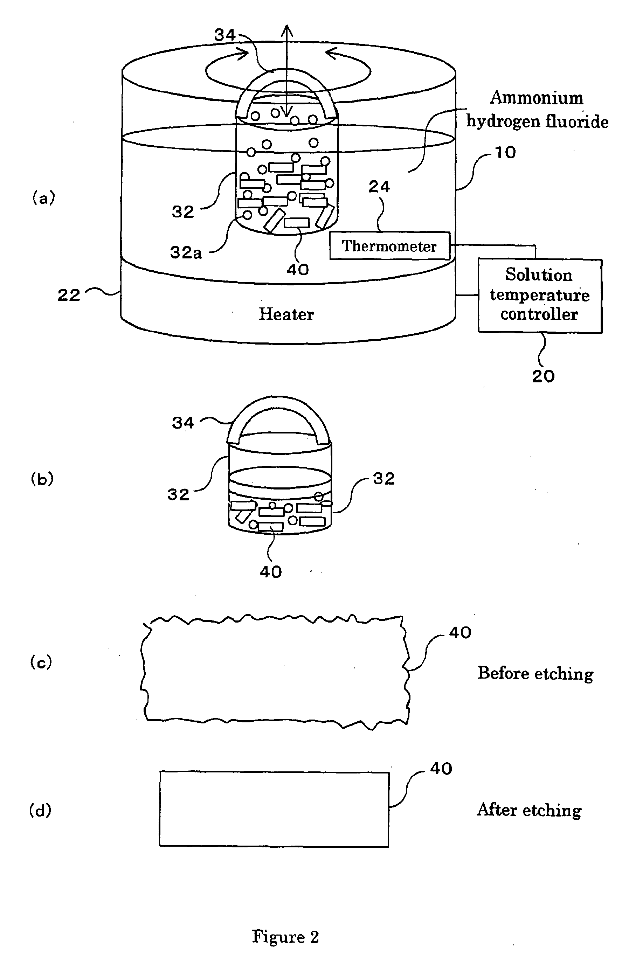

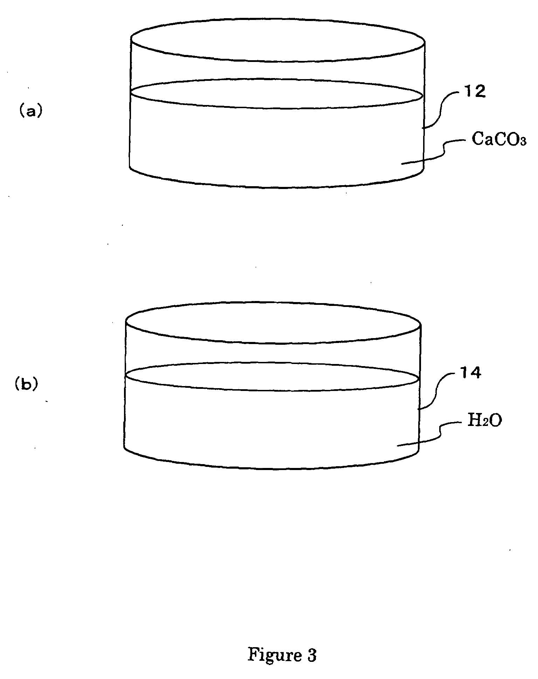

First, a construction of a first embodiment is described. FIGS. 2 and 3 are views showing an etching apparatus for carrying out an etching method according to the first embodiment of the present invention. The etching apparatus includes an etching vessel 10, a neutralization vessel 12, a washing vessel 14, a solution temperature controller 20, a heater 22, a thermometer 24, a basket 32, and a basket grip member 34.

Referring first to FIG. 2, the etching vessel 10 is a chemical resistant vessel. The etching vessel 10 is, for example, an alumina pan or a stainless steel pan having an inner wall coated with Teflon (Teflon) or platinum. Ammonium hydrogen fluoride solution prepared by dissolving 500 g of ammonium hydrogen fluoride into an equal amount of 500 cc of pure water is placed in the etching vessel 10. It is to be noted that, although the solution is required only to be acid solution which can be used for etching, ammonium hydrogen fluoride solution is used here.

Referring to FIG. 3, calcium carbonate solution is placed in the neutralization vessel 12. Pure water is placed in the washing vessel 14.

Referring back to FIG. 2, the heater 22 heats the ammonium hydrogen fluoride solution in the etching vessel 10. The thermometer 24 measures the temperature of the ammonium hydrogen fluoride solution in the etching vessel 10. The controller 26 compares a temperature which the ammonium hydrogen fluoride solution should have and a result of the measurement of the thermometer 24 and controls the heater 22 to control the temperature of the ammonium hydrogen fluoride solution.

The etching speed can be controlled by controlling the temperature of the ammonium hydrogen fluoride solution. Generally, as the solution temperature rises, the etching speed increases. For example, if the temperature of solution prepared by dissolving 500 g of ammonium hydrogen fluoride into 500cc of pure water is heated to 128°C, then the etching speed is approximately 1.6 *µ* m/minute. It is to be noted that the etching speed is an extent over which a workpiece is shaved per one minute. For example, where the etching speed is 1.6 *µ*m/minute, the thickness of a mesa worked portion of crystal which has a thickness of 80 *µ*m becomes less than 1 *µ*m in approximately 50 minutes by etching from one side, but in approximately 25 minutes by etching from the opposite sides.

The basket 32 is a beaker made of Teflon and has through-holes 32a formed in a side wall and a bottom thereof. Crystal 40 which is a workpiece to be etched is placed in the basket 32. For example, the crystal has a shape of a plate, and several hundreds to one thousand quarts plates are in the basket 32.

The crystal 40 has a shape of a plate produced by cutting, for example, from natural crystal, a raw ore of crystal artificially grown by hydrothermal synthesis or a raw ore of swept crystal and polishing the same. However, in the present embodiment, since the etching speed is comparatively high, polishing is not necessarily required. In other words, crystal which has been cut but has not been polished as seen in (c) of FIG. 2 may be used. This is because, since particularly high speed etching from within etching is isotropic working and a workpiece such as crystal is worked in any direction, the high speed etching itself serves also as a polishing step.

Consequently, if high speed etching is performed for such cut quarts as shown in (c) of FIG. 2, then the surface thereof becomes a mirror face as seen in (d) of FIG. 2 and besides has no burr.

The growth speed of an artificial crystal Z plate is 0.5 *µ*m/minute in the X direction, 0.25 *µ*m/minute in the Z direction, and 1.54 *µ*m/minute in the Y direction which is the thicknesswise direction of the crystal. It is to be noted that, while the workpiece in the first embodiment is crystal, it may alternatively be AlPO4, Quartz, LiTaO₃, LiNbO₃ or Li₂B₄O₇.

The basket 32 is soaked in the etching vessel 10, neutralization vessel 12 and washing vessel 14. The solution placed in the etching vessel 10, neutralization vessel 12 or washing vessel 14 circulates in the inside of the basket 32 through the through-holes 32a of the basket 32.

The basket grip member 34 is in a sense a handle for gripping the basket 32. By griping the basket grip member 34, the basket 32 can be moved upwardly or downwardly or turned to the left or the right.

It is to be noted that, where only one basket 32 is used as shown (a) of FIG. 2, the crystal 40 may possibly float on the dissolved ammonium hydrogen fluoride solution. Therefore, preferably two baskets 32 placed one on the other as shown in (b) of FIG. 2 are used. The crystal 40 is placed in a gap between the upper basket 32 and the lower basket 32. Even if the crystal 40 tends to float, since the bottom of the upper basket 32 serves as a lid, the crystal 40 can be prevented from floating.

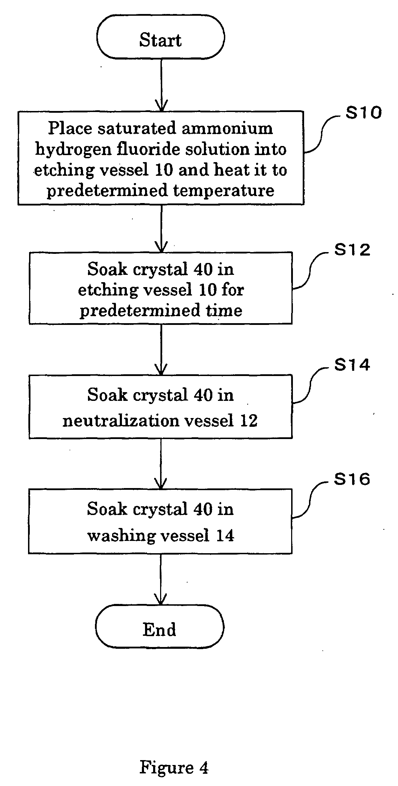

Subsequently, operation of the first embodiment is described with reference to a flow chart of FIG. 4. First, saturated ammonium hydrogen fluoride solution prepared by dissolving 500 g of ammonium hydrogen fluoride into an equal amount of 500 cc of pure water is placed into the etching vessel 10, and the solution temperature is raised to a predetermined temperature, for example, 128°C (S10). If the solution temperature is raised to 128°C, then the etching speed becomes approximately 1.6 *µ*m/minute. The crystal 40 which is a workpiece is artificial crystal as hereinafter described, and the growth speed of crystal is 0.5 µm/minute in the X direction, 0.25 *µ*m/minute in the Z direction, and 1.54 *µ*m/minute in the Y direction which is the thicknesswise direction of the crystal. Consequently, the etching speed is higher than the crystal growth speed.

Then, the opposite surfaces of crystal of *φ* 2 mm to be mesa worked are exposed at a central portion of an AT-cut crystal plate of *φ*5 mm of resonant frequency of 19 MHz cut from a synthesis crystal pure Z plate (unswept crystal) and polished into a mirror surface, and conductive bonding agent in which silver particles are included is applied to a thickness of approximately 100 *µ*m to peripheral portions of approximately 1.5 mm from the outer periphery of the crystal plate on the front and the rear. It is to be noted that the conductive bonding agent functions as a protective film, and the portions to which the conductive bonding agent is applied are not etched. In other words, masking is performed by the conductive bonding agent. It is to be noted that it is otherwise possible to use, for the masking, a member formed as a thin film of a two-layer structure of a substrate of Cr of 200 Å and Au of 3,000 Å. Generally, a member formed as a thin film of a two-layer structure of a substrate of Cr of 200 Å and Au 3,000 Å is used to obtain a Fine Pattern, that is, a precise masking pattern.

Several hundreds to one thousand such crystal plates 40 are placed into the basket 32, and the basket 32 is placed into the etching vessel 10 and soaked in the saturated ammonium hydrogen fluoride solution for a predetermined time, for example, for 20 minutes (S12). While the basket 32 is soaked in the saturated ammonium hydrogen fluoride solution, the basket 32 is oscillated upwardly and downwardly and turned leftwardly and rightwardly. By soaking the basket 32 in the saturated ammonium hydrogen fluoride solution, the crystal 40 is etched.

After the etching for the predetermined time is completed, the basket 32 is removed from the etching vessel 10 and placed into the neutralization vessel 12. Consequently, the crystal 40 is soaked in the calcium carbonate solution which is neutralization solution (S14). By the neutralization, the etching is stopped. Finally, the basket 32 is removed from the neutralization vessel 12 and placed into the pure water vessel 14. Consequently, the crystal 40 is washed (S16).

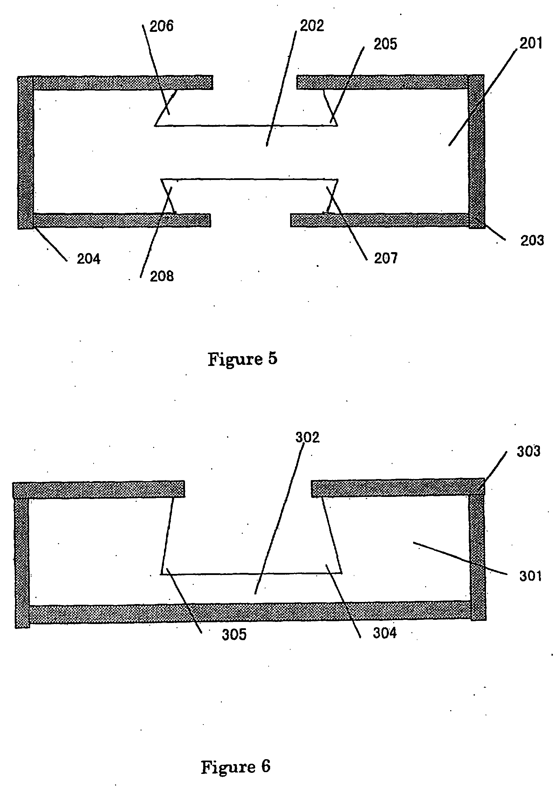

A cross section of a crystal plate 40 etched in this manner is shown in FIGS. 5 and 6. FIG. 5 illustrates etching of a crystal plate 201 from the two front and rear faces, and FIG. 6 illustrates etching of another crystal plate 301 from the one front face.

As shown in FIG. 5, protective films 203 and 204 are formed on the crystal plate 201 so that the crystal plate 201 is not etched. The protective films 203 and 204 are formed by applying conductive bonding agent, which includes silver particles, to the crystal plate 201. Etching is performed at the other portion of the crystal plate 201 at which the protective films 203 and 204 are not present, and side etch portions 205, 206, 207 and 208 are formed as the etching proceeds.

As shown in FIG. 6, a protective film 303 is formed on the crystal plate 301 so that the crystal plate 301 is not etched. The protective film 303 is formed by applying a conductive bonding agent, which includes silver particles, to the crystal plate 301. Etching is performed at the other portion of the crystal plate 301 at which the protective film 303 is not present, and side edge portions 304 and 305 are formed as the etching proceeds.

The etching speed of 1.6 µm/minute for crystal is obtained in this manner. In 20 minutes after the etching is started, a mesa worked crystal plate which operates with a fundamental mode of 70 MHz at the mesa location at the central portion of ⌀2 mm is obtained. Observation of the mesa worked surfaces proves that neither etch channel nor etch pit is found.

In particular, the etching speed of 1.6 *µ*m/minute is obtained by setting the temperature of the ammonium hydrogen fluoride solution in the etching vessel 10 to 128°C. Therefore, since the etching speed is higher than the maximum value 1.54 *µ*m/minute of the crystal growth speed of the crystal 40, neither etch channel nor etch pit is produced. The inventor of the present application has discovered that, as the etching speed rises, such defects of etch channels and etch pits decrease. Also it has been discovered by the inventor of the present application that, particularly where the etching speed is higher than the crystal growth speed of a workpiece, appearance of etch channels and etch pits decreases remarkably.

### Second Embodiment

The second embodiment involves addition of calculation of the etching speed and time to the first embodiment.

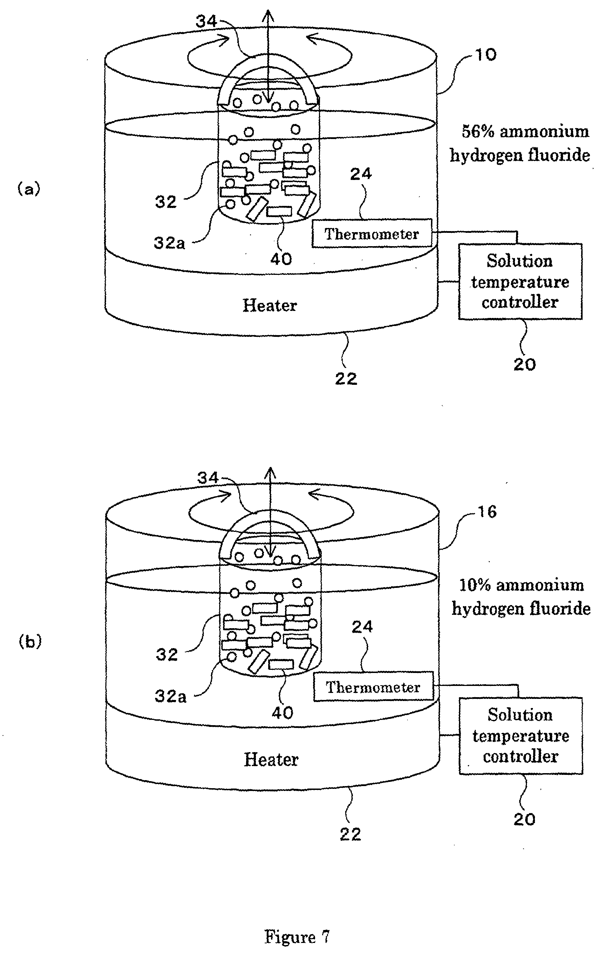

FIG. 7 is a view showing an etching apparatus for carrying out an etching method according to the second embodiment of the present invention. The etching apparatus of the second embodiment includes etching vessels 10 and 16, a neutralization vessel 12, a washing vessel 14, a solution temperature controller 20, a heater 22, a thermometer 24, a basket 32, and a basket grip member 34.

The etching vessels 10 and 16 are similar to that of the first embodiment, and therefore, description thereof is omitted. The etching vessels 10 and 16 are shown in (a) and (b) of FIG. 7, respectively. In the etching vessel 10, 56 % ammonium hydrogen fluoride solution is poured. The etching vessel 10 is used to work crystal 40. In the etching vessel 16, 10 % ammonium hydrogen fluoride solution is poured. The etching vessel 16 is used to measure an etching speed. It is to be noted that the neutralization vessel 12 and the washing vessel 14 are similar to those of the first embodiment and have similar constructions to those of FIG. 3. Therefore, the neutralization vessel 12 and the washing vessel 14 are not shown in (a) and (b) of FIG. 7. Reference should be had to FIG. 3.

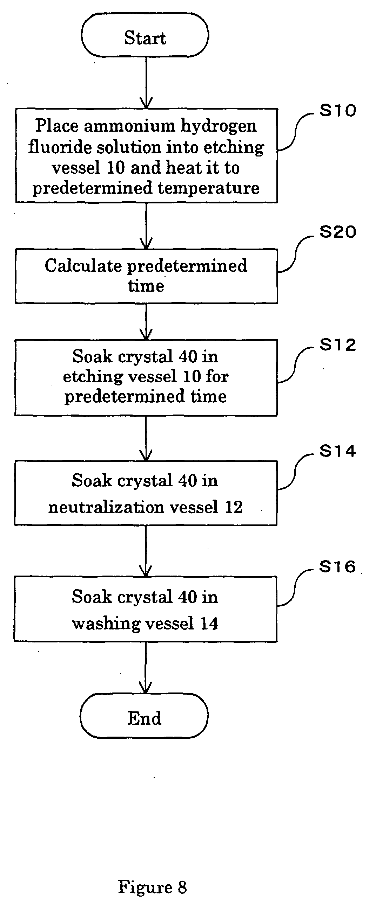

Subsequently, operation of the second embodiment is described with reference to a flow chart of FIG. 8. First, in the etching vessel 10, 840 g of ammonium hydrogen fluoride is dissolved into 660 cc of pure water to produce 1.5 litters of ammonium hydrogen fluoride solution, and the solution temperature is raised to a predetermined temperature, for example, 110°C (S10). If the solution temperature is raised to 110°C, then the etching speed is higher than the growth speed of crystal. The 56 % ammonium hydrogen fluoride solution is produced in the etching vessel 10 in this manner.

Further, in the etching vessel 16, 150 g of ammonium hydrogen fluoride is dissolved into 1,350 cc of pure water to 1.5 litters of ammonium hydrogen fluoride solution, and the solution temperature is raised to a predetermined temperature, for example, 80°C-90°C (S10). However, in order to allow ammonium hydrogen fluoride to be dissolved fully, preferably the solution temperature is controlled to 80°C-90°C after it is raised to 100°C or more once. The 10 % ammonium hydrogen fluoride solution is produced in the etching vessel 16 in this manner.

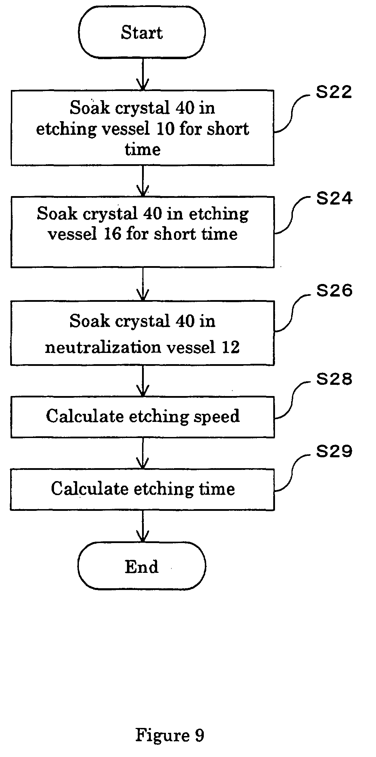

Then, a predetermined time for which etching is to be performed is calculated (S20). A calculation procedure of the predetermined time is illustrated in FIG. 9.

First, the opposite surfaces of crystal of ⌀2 mm to be mesa worked are exposed at a central portion of an AT-cut crystal plate of ⌀5 mm of resonant frequency of 19 MHz cut from a synthesis crystal pure Z plate (unswept crystal) and polished into a mirror surface, and conductive bonding agent in which silver particles are included is applied to a thickness of approximately 100 *µ*m to peripheral portions of approximately 1.5 mm from the outer periphery of the crystal plate on the front and the rear. It is to be noted that the conductive bonding agent functions as a protective film, and the portions to which the conductive bonding agent is applied are not etched. In other words, masking is performed by the conductive bonding agent. It is to be noted that it is otherwise possible to use, for the masking, a member formed as a thin film of a two-layer structure of a substrate of Cr of 200 Å and Au of 3,000 Å. Generally, a member formed as a thin film of a two-layer structure of a substrate of Cr of 200 Å and Au 3,000 Å is used to obtain a Fine Pattern, that is, a precise masking pattern.

Several hundreds to one thousand such crystal plates 40 are placed into the basket 32, and the basket 32 is placed into the etching vessel 10 and soaked in the 56 % ammonium hydrogen fluoride solution for a short time, for example, for 30 seconds (S22). While the basket 32 is soaked in the 56 % ammonium hydrogen fluoride solution, the basket 32 is shaken upwardly and downwardly and turned leftwardly and rightwardly. By soaking the basket 32 in the saturated ammonium hydrogen fluoride solution, the crystal 40 is etched for the short time.

Then, the basket 32 is placed into the etching vessel 16 and soaked in the 10 % ammonium hydrogen fluoride solution for a short time, for example, for 10 to 20 seconds (S24). While the basket 32 is soaked in the 10 % ammonium hydrogen fluoride solution, the basket 32 is shaken upwardly and downwardly and turned leftwardly and rightwardly. By immersing the crystal 40 in the ammonium hydrogen fluoride solution of the low concentration, the etching is stopped gradually.

Then, the basket 32 is removed from the etching vessel 16 and placed into the neutralization vessel 12. Consequently, the crystal 40 is soaked in the calcium carbonate solution which is neutralization solution (S24). By the neutralization, the etching is stopped.

Here, the thickness of the crystal 40 is measured, and a difference between the thickness and the original thickness of the crystal 40 is determined. This is a thickness etched by the etching. The thickness etched by the etching is divided by the time for which the crystal 40 has been kept soaked in the 56 % ammonium hydrogen fluoride solution to calculate an etching speed (S28). For example, if the crystal 40 is kept soaked in the 56 % ammonium hydrogen fluoride solution for 30 seconds and the one face of the crystal 40 is etched by 1.1 *µ*m by the etching, then the etching speed is 1.1/0.5=2.2 *µ*m/minute.

Thereafter, an etching time is calculated from the etching speed (S29). In particular, the thickness to be etched is divided by the etching speed. For example, when one face of the crystal 40 is to be etched by 10 *µ*m by etching, if the etching speed is 2.5 *µ*m/minute, then the etching time is 10/2.5 = 4 minutes.

Here, reference is returned to FIG. 8. Several hundreds to one thousand such crystal plates 40 are placed into the basket 32, and the basket 32 is placed into the etching vessel 10 and soaked in the saturated ammonium hydrogen fluoride solution for the predetermined time, that is, for the time calculated as above (S12). While the basket 32 is soaked in the 56 % ammonium hydrogen fluoride solution, the basket 32 is shaken upwardly and downwardly and turned leftwardly and rightwardly. By soaking the basket 32 in the saturated ammonium hydrogen fluoride solution, the crystal 40 is etched. It is to be noted that, after the etching for the predetermined time is completed, the basket 32 may be placed into the etching vessel 16 in which the 10 % ammonium hydrogen fluoride solution is placed to effect fine adjustment of the etching.

After the etching for the predetermined time is completed, the basket 32 is removed from the etching vessel 10 and placed into the neutralization vessel 12. Consequently, the crystal 40 is soaked in the calcium carbonate solution which is neutralization solution (S14). By the neutralization, the etching is stopped. Finally, the basket 32 is removed from the neutralization vessel 12 and placed into the pure water vessel 14. Consequently, the crystal 40 is washed (S16).

With the second embodiment, since the etching speed becomes apparent, an etching time can be calculated. Consequently, the time for which etching should be performed can be determined accurately and etching can be performed precisely.

It is to be noted that the etching speeds of crystal in the first and second embodiments are mere examples at all. Depending upon setting of the concentration or the temperature of ammonium hydrogen fluoride solution, even an etching speed higher than 10 *µ*m/minute is possible. Since control itself of the etching speed is well known in the art, description of it is omitted.

For example, in the case of the etching speed of 10 *µ*m/minute, if the two front and rear faces are etched, then crystal of the thickness of 150 *µ*m/minute (operating frequency 10.6 MHz) is reduced to 150 - 2 × 3.5 × 10 = 80 *µ*m in thickness (operating frequency 20 MHz) in 3 minutes and 30 seconds.

In this instance, since the etching is high speed etching, this provides an effect similar to that when the surface is polished, and consequently, Q factor of the crystal is high. Besides, if unnecessary burr is present on end faces, then unnecessary (spurious) responses are generated, and the crystal becomes weak also to a mechanical impact. Thus, since burr on end faces can be removed readily by high speed etching, unnecessary (spurious) responses of the crystal are prevented and the crystal becomes tough also against a mechanical impact.

In particular, in order to prevent an etch channel or an etch pit, high speed etching is performed, and this gives rise even to an effect that Q factor of crystal is raised and unnecessary (spurious) responses are prevented and besides the crystal becomes tough against a mechanical impact.

Further, with the first and second embodiments, the quartz crystal oscillator of the present invention is directed to a crystal plate having a fundamental mode operating frequency higher than 50 MHz, and if the physical thickness of a crystal plate of, for example, 5 mm ⌀ is selectively set to 80 *µ*m (which corresponds to crystal of 20 MHz), then it contributes very much also to augmentation in yield in a manufacturing process in an assembly process. Particularly by suitably selecting the thickness of a crystal plate which is a workpiece, an Etch Pit which appears upon etching can be suppressed while the physical thickness of the crystal plate is kept to 80 *µ*m, and consequently, it is very easy in manufacture to realize a crystal plate, which operates with 100 MHz (the thickness of a diaphragm portion is 16.7 µm), while keeping high quality (HQ). Since the diaphragm area necessary as an oscillation region can be reduced with a higher frequency, a quartz crystal oscillator which is superior in environmental condition against an external environment such as a shock or vibrations is obtained by making the outer profile small.

With a mesa worked crystal plate of a diaphragm structure of the present invention, a frequency-temperature characteristic pattern of a cubic curve which an AT cut crystal plate which makes use of thickness responses has can be realized over a wide frequency range from 50 MHz to Several Hundreds MHz or more.

Where etching solution which includes hydrofluoric acid as a principal component is used, an SC-cut crystal plate is an object of mesa working. Since the manufacturing method according to the present invention is very high speed etching, it can work a large amount of crystal in a batch in a short time and additionally has an effect of mass production. The very high speed etching method of the present invention is isotropic etching and can realize a superior quartz crystal oscillator by which also a dispersion in temperature characteristic arising from a displacement of a cut angle by local working inequality which has been pointed out as a problem in mesa working by anisotropic etching and which conventionally occurs when the etching speed is low can be suppressed small and which is free from a through-hole by an Etch Channel or surface roughness (Etch Pit) and high in Q factor. Also it is a significant characteristic that the influence of the residual stress upon working of crystal is little.

As described above, the mesa worked crystal plate of the present invention is characterized in that, by raising the etching speed significantly while a conventional manufacturing method of mesa working blanking is traced, mesa working by which a fundamental mode operating frequency can be raised while keeping high quality (HQ) is possible. It is the most significant point to raise the fundamental mode operating frequency higher than the speed at which crystal is grown. The mesa worked crystal plate of the present invention is characterized in that, with ammonium hydrogen fluoride, a frequency-temperature characteristic pattern of a cubic curve which an AT-cut crystal plate which makes use of thickness responses has can be realized in a very short time over a wide frequency range from 50 MHz to Several Hundreds MHz or more. With etchant which includes hydrofluoric acid as a principal component, an SC-cut crystal plate is an object of mesa working. Since the manufacturing method according to the present invention is very high speed etching, it can work a large amount of crystal in a batch in a short time and additionally has an effect of mass production. Also it is a significant characteristic that the influence of the residual stress upon working of crystal is little.

### Industrial Applicability of the Invention

In this manner, the present invention not only is high in its industrial value but has a very great influence on the industry, and the field of application of it is not limited to monolithic crystal filters but has the possibility that the field of application can be widened also to the field of sensors. Consequently, the practical utility of it is very high.

## Claims

1. An etching method wherein a workpiece having crystal is soaked in acid solution, wherein
an etching speed is higher than a crystal growth speed of the workpiece.

2. An etching method, comprising:
a pre-etching step of soaking a workpiece having crystal in acid solution;
an etching speed calculation step of calculating an etching speed in the pre-etching step;
an etching time calculation step of calculating an etching time for which etching should be performed from the calculated etching speed; and
a main etching step of soaking the workpiece in acid solution for the etching time;
the etching speed being higher than a crystal growth speed of the workpiece.

3. An etching method according to claim 2, further comprising:
next to the pre-etching step,
a step of soaking the workpiece in a low speed etching acid solution whose etching speed is lower than the etching speed of the acid solution.

4. An etching method according to any one of claims 1 to 3, wherein the acid solution has a temperature higher than 100°C.

5. An etching method according to any one of claims 1 to 3, wherein the acid solution is solution in which ammonium hydrogen fluoride or hydrofluoric acid is dissolved.

6. An etching method according to any one of claims 1 to 3, wherein the workpiece is crystal.

7. An etching method according to claim 6, wherein the workpiece is crystal produced by cutting from natural crystal, a raw ore of artificial crystal grown by hydrothermal synthesis or a raw ore of swept crystal.

8. An etching method according to any one of claims 1 to 3, wherein the workpiece is one of AlPO4, Quartz, LiTaO₃, LiNbO₃ and Li₂B₄O₇.

9. A workpiece worked by an etching method as set forth in any one of claims 1 to 8.

10. A vessel made of Teflon and having a through-hole in a side wall or a bottom thereof.

11. A vessel, comprising:
an upper vessel made of Teflon and having a through-hole in a side wall or a bottom thereof; and
a lower vessel made of Teflon and having a through-hole in a side wall or a bottom thereof;
said upper vessel being placed on said lower vessel.
